# EUROPEAN PATENT APPLICATION

(11) **EP 4 525 029 A1**
(43) Date of publication of application: **19.03.2025**
(21) Application number: 23198041.8
(22) Date of filing: 18.09.2023
(51) Int. Cl.: H01L 21/67, H01L 21/68

(54) **SUBSTRATE COUPLING SYSTEMS**

(71) Applicant: ASML Netherlands B.V., 5500 AH Veldhoven (NL)
(72) Inventor: HSU, CHIA-HAO, 5500 AH Veldhoven (NL)
(74) Representative: ASML Netherlands B.V.

(57) **Abstract**

Current substrate (e.g., semiconductor wafer) coupling (e.g., bonding) process control methodology uses measured substrate flatness and shape to control the coupling process. Current equipment configurations and coupling processes introduce high substrate (e.g., semiconductor wafer edge) distortion that causes pronounced non-correctable (e.g., overlay and/or other) errors, and significant substrate-to-substrate distortion variation because the current coupling processes are highly substrate material property dependent. The measured flatness and shape do not provide sufficient indications of these substrate material properties. Advantageously, in the described systems and methods, key substrate material properties, such as elastic modulus (E), geometrical properties (I), and deformation moments (M), are determined for a specific substrate just prior to coupling based on directly measured substrate deformation, then provided as feedback for real-time adjustments to the coupling process for that substrate.

## Description

### TECHNICAL FIELD

This description relates to substrate coupling systems and methods.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, joined, or otherwise coupled (e.g., to heterogeneous or homogeneous devices) at various points in the fabrication process. The integration of different substrates, circuits, or other patterned devices may rely upon joining of specific portions (for example, conductive contact elements) of multiple die-where these specific portions which may be aligned in three-dimensional space to ensure functional connectivity. As the physical sizes of IC components continue to shrink, and their structures continue to become more complex, accuracy, minimization of distortion and variability, and throughput in coupling become more important. In the context of semiconductor manufacture, improvements in substrate placement and joining lead to improvements in IC manufacturing and integration abilities.

### SUMMARY

Current substrate (e.g., semiconductor wafer) coupling (e.g., bonding) process control methodology uses measured substrate flatness and shape to control the coupling process. Current equipment configurations and coupling processes introduce high substrate (e.g., semiconductor wafer edge) distortion that causes pronounced non-correctable (e.g., overlay and/or other) errors, and significant substrate-to-substrate distortion variation because the current coupling processes are highly substrate material property dependent. The measured flatness and shape do not provide sufficient indications of these substrate material properties. Advantageously, in the systems and methods described below, key substrate material properties are determined for a specific substrate just prior to coupling based on directly measured substrate deformation, then provided as feedback for real-time adjustments to the coupling process for that substrate.

According to an embodiment, a substrate coupling system is provided. The system comprises a substrate holder configured to hold a first substrate to enable the first substrate to be coupled to a second substrate. The system comprises an actuator coupled to the substrate holder. The actuator is configured to apply a first force to the first substrate that causes the first substrate to deform away from the substrate holder toward the second substrate. The system comprises a sensor coupled to the substrate holder. The sensor is configured to generate one or more output signals indicating deformation of the first substrate toward the second substrate caused by the first force. The system comprises a controller (e.g., including one or more processors) operatively coupled to the substrate holder, the actuator, and the sensor. The controller is configured to determine a second force for coupling the first substrate to the second substrate based on the first force and the output signals.

In some embodiments, the substrate holder comprises a chuck, the first substrate and the second substrate comprise semiconductor wafers or dies, and coupling the first substrate to the second substrate comprises bonding the first substrate to the second substrate.

In some embodiments, the actuator comprises a transmitter configured to receive a control signal from the controller to cause the actuator to apply the first force, a pin configured to push on the first substrate, a motor configured to move the pin, and a load cell configure to generate an output signal indicating the first force.

In some embodiments, the first force comprises a force pulse. The force pulse comprises a peak force, and a velocity with which the peak force is applied and/or removed. The actuator is configured to apply the first force to a discrete portion of the first substrate at or near a center of the first substrate. The portion of the first substrate together with its immediate surrounding deforms away from the substate holder, toward the second substrate as a result of the first force, without other areas of the first substrate separating from the substrate holder.

In some embodiments, the sensor comprises one or more electrodes configured to measure capacitance indicating the deformation of the first substrate toward the second substrate caused by the first force. An electrode is configured to induce local positive and/or negative charges in the substrate holder, and measure the capacitance based on the local positive and/or negative charges in the substrate holder. In some embodiments, the sensor comprises a plurality of electrodes coupled to the substrate holder in a plurality of locations. The plurality of locations are configured to facilitate measurement of capacitances in the plurality of locations across the first substrate. The plurality of electrodes comprise two electrodes each distributed at angles of 0°, 45°, 90°, 135°, 180°, 225°, 270°, and 315° around the substrate holder. The controller is configured to determine the second force for coupling the first substrate to the second substrate based on the capacitances in the plurality of locations, and the first force. In some embodiments, the controller is configured to convert a measured capacitance to a deformation distance between the substrate holder and the first substrate, and determine the second force for coupling the first substrate to the second substrate based on deformation distances, and the first force.

In some embodiments, the controller is configured to control the actuator to apply multiple different forces to the first substrate that cause the first substrate to deform away from the substrate holder in different corresponding amounts toward the second substrate. The one or more output signals generated by the sensor indicate the different corresponding amounts of deformation. The controller is configured to determine the second force for coupling the first substrate to the second substrate based on the multiple different forces and the different corresponding amounts of deformation indicated in the output signals.

In some embodiments, the system comprises a gas (e.g., air or other gases) source operably coupled to the controller and the substrate holder, and configured to generate a pressurized flow of gas to push the first substrate away from the substrate holder toward the second substrate. The gas source is controlled by the controller.

In some embodiments, the controller is configured to: determine material property information including an elastic modulus (E) for the first substrate, determine geometrical property (I) information for the first substrate, and/or determine a moment (M), based on the first force and the deformation indicated in the output signals, and determine the second force for coupling the first substrate to the second substrate based on the material property information, the geometrical property information, and/or the moment. In some embodiments, the controller is configured to determine: a velocity (V) with which the actuator is to apply the second force, a separation distance (D) between the first substrate and the second substrate, a release timing (T) of the first substrate, and/or a pressure (P) of a pressurized flow of gas configured to push the first substrate toward the second substrate, in addition to the second force (F), for coupling the first substrate to the second substrate, based on the deformation indicated in the output signals and the first force.

In some embodiments, the substrate holder comprises: burls configured to contact the first substrate, a plurality of vacuum channels coupled to a vacuum configured to provide a vacuum force to hold the first substrate against the burls; and a second actuator configured to move the substrate holder and the first substrate relative to the second substrate. The vacuum and the second actuator are controlled by the controller.

In some embodiments, the system comprises a second substrate holder configured to hold the second substrate. The second substrate holder comprises second burls configured to contact the second substrate, and a second plurality of vacuum channels configured to provide a second vacuum force controlled by the controller to hold the second substrate against the second burls.

According to another embodiment, a coupling method comprising one or more of the operations described above is provided.

### BRIEF DESCRIPTION OF THE DRAWINGS

The above aspects and other aspects and features will become apparent to those ordinarily skilled in the art upon review of the following description of specific embodiments in conjunction with the accompanying figures.
Fig. 1 illustrates a typical bonding process flow, according to an embodiment.
Fig. 2 re-illustrates several operations of the process flow shown in Fig. 1, with an additional illustration of deformation associated with an elastic wave that may occur during the process flow, according to an embodiment.
Fig. 3 illustrates a typical bonding process metrology and inspection flow for controlling a bonding process like the one shown in Fig. 1 and 2, according to an embodiment.
Fig. 4 illustrates a new substrate coupling system, according to an embodiment.
Fig. 5 provides an enlarged view of a sensor of the system shown in Fig. 4 (in a top view), according to an embodiment.
Fig. 6 illustrates a new bonding process metrology and inspection flow for controlling a bonding process using the system shown in Fig. 4 (and Fig. 5), according to an embodiment.
Fig. 7 illustrates a substrate coupling method, according to an embodiment.
Fig. 8 schematically depicts a lithography apparatus, according to an embodiment.
Fig. 9 illustrates a schematic representation of holistic lithography, representing a cooperation between three technologies to optimize semiconductor processing, according to an embodiment.
Fig. 10 is a block diagram of an example computer system, according to an embodiment.

### DETAILED DESCRIPTION

Coupling techniques, such as dielectric coupling, fusion, hybrid bonding, etc., facilitate minimization of distortion and variability, and throughput in semiconductor manufacturing processes. Coupling techniques often require a center pin to push one substrate toward another to initiate a coupling process. However, once the coupling process is initiated, an elastic wave is generated and propagates outward through the pushed substrate all the way out to the edge of the substrate. Elastic wave propagation is highly substrate (material) property and coupling process parameter dependent. In order to minimize the distortion and other variability caused by this elastic wave, substrate by substrate coupling process optimization would be helpful.

Current substrate (e.g., semiconductor wafer) coupling (e.g., bonding) process control methodology uses measured substrate flatness and shape to control the coupling process. The measured flatness and shape often do not provide sufficient indications of individual substrate material properties for accurate coupling. Advantageously, in the systems and methods described below, key substrate material properties, such as elastic modulus (E), geometrical properties (I), and deformation moments (M), are determined for a specific substrate just prior to coupling based on directly measured substrate deformation, then provided as feedback for real-time adjustments to the coupling process for that substrate.

For example, in the present systems and methods, electrode(s) and/or a distribution of electrodes on or inside a holder or chuck form sensors used for measuring the deformation of an individual substrate (electrostatically) at certain input forces, before that substrate is coupled to another substrate. The input forces comprises different force pulses which do not yet cause release of the substrate from the holder, but instead only deform the substrate sufficiently enough to determine the (material) properties of the individual substate. Force versus deformation information can be used to determine material properties of the substrate. An optimized input force, substrate to substrate distance, and/or other coupling process parameters are then determined for that substrate based on the properties of that substrate. This individual, customized, coupling process enhances accuracy of the coupling process for the substrate.

In an embodiment the electrodes can also be electrostatic clamping electrodes: and so, could have two functions, one for measuring the properties of a substrate, and one for clamping the substrate before coupling.

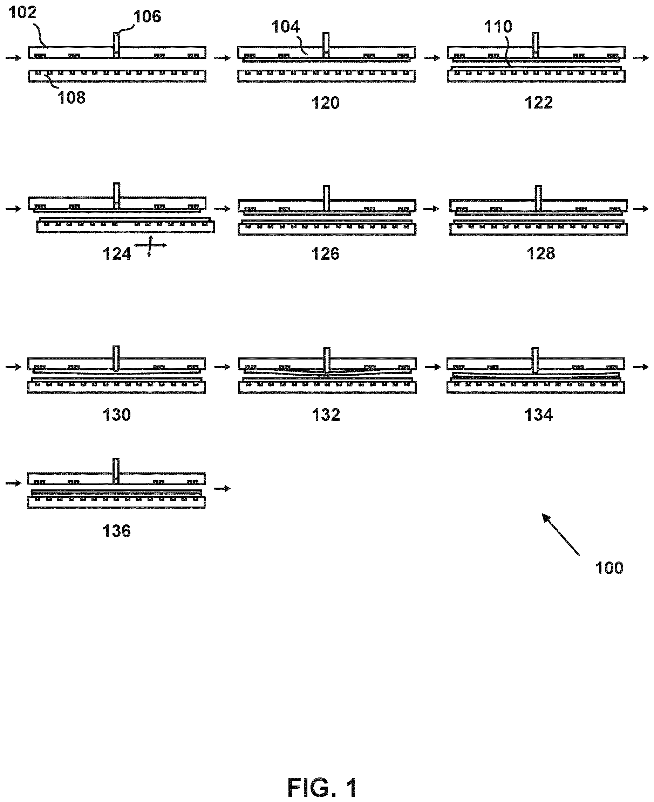

By way of an introduction, Fig. 1 illustrates a typical bonding process flow 100. Fig. 1 illustrates a top chuck 102 holding a top wafer 104, a pin or piston 106, and a bottom chuck 108 holding a bottom wafer 110 throughout several operations of process flow 100. Top chuck 102 and bottom chuck 108 each comprise burls configured to contact a wafer, vacuum channels configured to provide a vacuum force to hold a wafer against the burls, an actuator configured to move the chuck and/or various other components necessary for bonding process flow 100. At operation 120, top wafer 104 is loaded onto top chuck 102. At operation 122, bottom wafer 110 is loaded onto bottom chuck 108. At operation 124, top wafer 104 and bottom wafer 110 are aligned. At operation 126 one and/or both chucks move to establish a specific separation distance between wafers 104 and 110. At operation 128 a bottom vacuum force is established between bottom chuck 108 and bottom wafer 110. At operation 130 a pin or piston 106 force is set. At operation 132 a top chuck inner vacuum force is released so that the center of top wafer 104 is pushed by the pin or piston 106 toward bottom wafer 110. At operation 134, a top chuck outer vacuum force is released so that the outer portions of top wafer 104 are pushed toward bottom wafer 110. This causes the elastic wave described herein to propagate across top wafer 104, for example. At operation 136, the pin or piston force is removed, because top wafer 104 is bonded to bottom wafer 110. Operations 130, 132, 134, and/or 136 are key to causing and/or avoiding variability, distortion, and/or other unwanted effects during bonding.

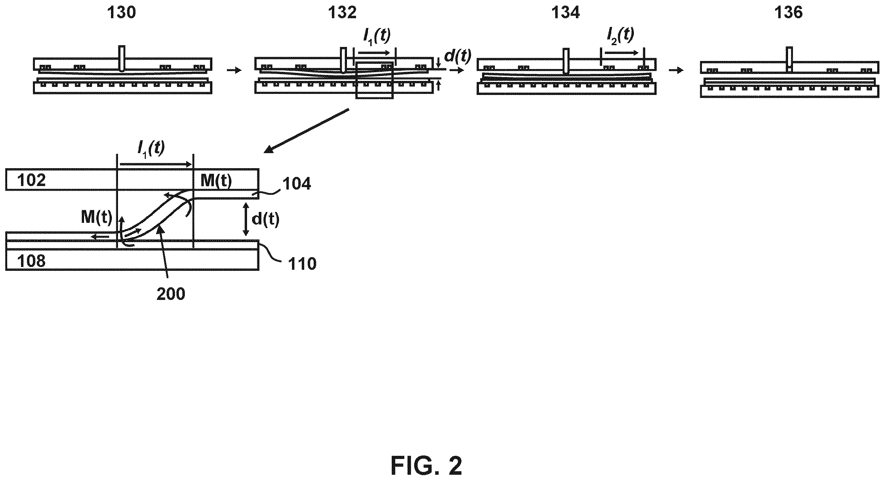

Fig. 2 re-illustrates several operations of process flow 100 shown in Fig. 1, with an additional illustration of deformation 200 associated with an elastic wave that may occur during process flow 100. Specifically, Fig. 2 re-illustrates operations 130-136 shown in Fig. 1. As a reminder, at operation 132, a top chuck inner vacuum force is released so that the center of top wafer 104 is pushed by the pin or piston 106 toward bottom wafer 110. This causes deformation 200, which propagates outward a distance 1 (e.g., see 1₁(t), which would progress to 1₂(t), 1₃(t), etc., across the wafer) from pin or piston 106 over time (t) as piston 106 pushes down on top wafer 104 as top wafer 104 is pushed toward bottom wafer 110, and then top wafer 104 is eventually fully released from top chuck 102 (at operation 134). A distance (d) between different portions of top wafer 104 and bottom wafer changes with time, d(t). Fig. 2 illustrates moments (M) that are created on opposite ends of a deformed portion of top wafer 104, which also vary with time as piston 106 pushes down on top wafer 104. At operation 134, a top chuck outer vacuum force is released so that the outer portions of top wafer 104 are pushed toward bottom wafer 110. This causes the elastic wave described herein to continue to propagate across top wafer 104 as the rest of top wafer 104 moves toward bottom wafer 110, for example. In some embodiments, a piston 106 force, size, and/or speed; material properties of top wafer 104; distance d between wafers; release timing; and/or other factors affect the wave propagation characteristics including velocity, shape (mode), amplitude, etc. This propagation is difficult to precisely control, and can cause uneven amounts of deformation, distortion, etc., during the bonding process. The propagation of the elastic wave on silicon, for example, may lead to silicon deformation. For example, if bonding progresses faster than elastic wave propagation (e.g., an early release for the illustrated top wafer), one may see deformation variation within a wafer (because the wave becomes trapped within the wafer). If bonding progresses slower than elastic wave propagation, one may see deformation variation at the wafer edge and/or other effects.

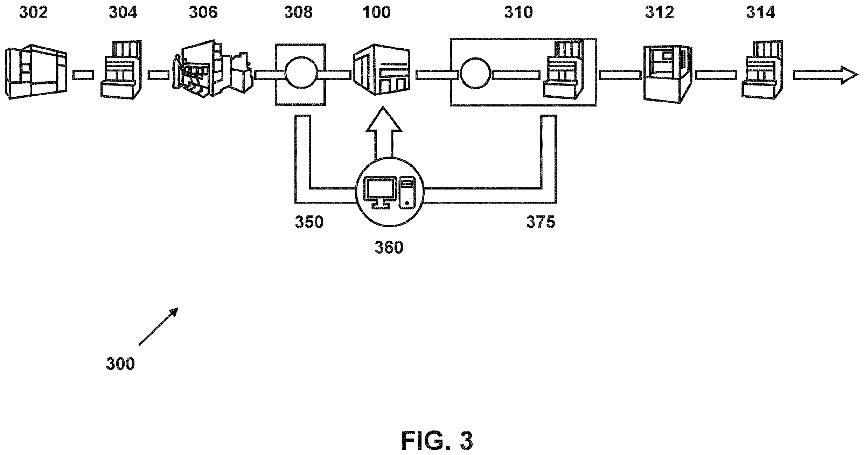

Fig. 3 illustrates a typical bonding process metrology and inspection flow 300 for controlling a bonding process like the one shown in Fig. 1 and 2. Flow 300 includes a patterning process such as lithography 302 performed on a substrate such as a wafer, metrology 304 for lithography 302, etching and metallization 306, pre-bonding metrology 308, bonding process flow 100, post-bonding metrology 310, grinding and etching 312, and after etching metrology 314. Note that lithography 302, metrology 304, etching and metallization 306, grinding and etching 312, and after etching metrology 314 are not the subjects of the present disclosure and so will not be focused on here. Instead, these processes are described in several other patents and patent applications from the same applicant.

At pre-bonding metrology 308, a global shape and flatness of the top and bottom wafers (e.g., see wafers 104 and 110 in Fig. 1 and 2) is measured. The measured shape and flatness is provided as feedforward input 350 (e.g., by a computer 360 controlling bonding) for bonding process adjustments in bonding process flow 100 for the top and bottom wafers and/or a current lot of wafers. At post-bonding metrology 310, the shape and flatness of the top and bottom wafers is re-measured. These measurements are provided as feedback 375 for additional bonding process adjustments for subsequent wafers in bonding process flow 100. However, the measured global wafer shape and flatness (pre and post bonding) typically does not provide enough information and/or is otherwise not sensitive enough for optimization and/or other correction of bonding process flow 100. The measured flatness and shape often do not provide sufficient indications of individual substrate material properties for accurate coupling. For example, distortion and/or deformation (e.g., see Fig. 2) can be localized on a wafer, for example. Indications of this local distortion and/or deformation may not be found in global shape and flatness data (in contrast to wafer specific material property data as described herein).

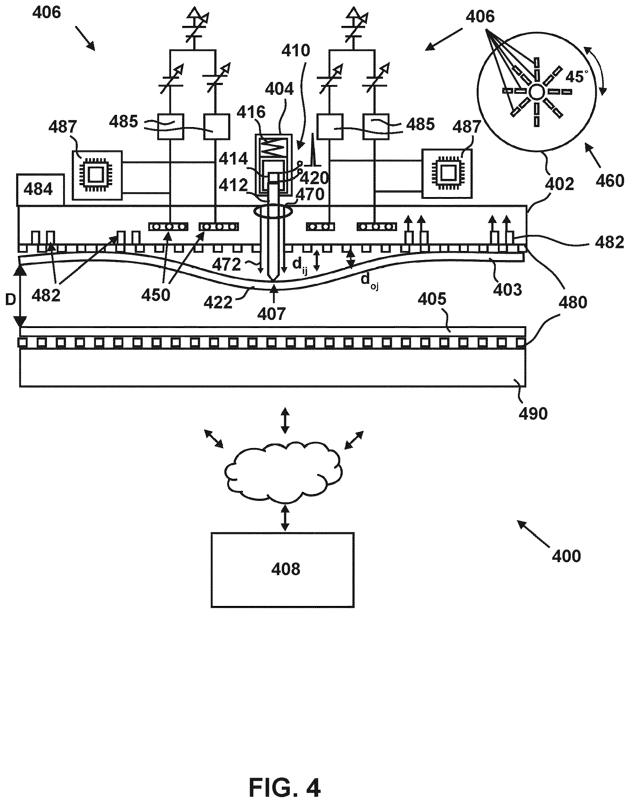

Fig. 4 illustrates a new substrate coupling system 400. System 400 comprises a substrate holder 402 configured to hold a first substrate 403 to enable first substrate 403 to be coupled to a second substrate 405. Substrate holder 402 may comprise a chuck, or a top chuck in this example, and/or other components. Substrates 403 and/or 405 may comprise semiconductor wafers, dies, and/or other substrates. Coupling may comprise bonding (e.g., dielectric, fusion, hybrid, etc.) and/or other types of coupling.

In some embodiments, substrate holder 402 comprises burls 480 configured to contact first substrate 403, a plurality of vacuum channels 482 coupled to a vacuum (not shown in Fig. 4) configured to provide a vacuum force to hold first substrate 403 against burls 480, an actuator 484 configured to move substrate holder 402 the first substrate 403 relative to second substrate 405, and/or other components. In some embodiments, system 400 comprises a second substrate holder 490 configured to hold second substrate 405. Second substrate holder 490 comprises additional burls 480 configured to contact second substrate 405, and a second plurality of vacuum channels (not shown in Fig. 4) configured to provide a second vacuum force to hold second substrate 405 against the burls.

System 400 comprises an actuator 404 coupled to substrate holder 402. Actuator 404 is configured to apply 407 a first force to first substrate 403 that causes first substrate 403 to deform away from substrate holder 402 toward second substrate 405. System 400 comprises a sensor 406 (or one or more sensors 406) coupled to substrate holder 402. Sensor 406 is configured to generate one or more output signals indicating deformation of first substrate 403 toward second substrate 405 caused by the first force. System 400 comprises a controller 408 (e.g., including one or more processors, a computing system, and/or other similar components) operatively coupled to substrate holder 402, actuator 404, sensor 406, the vacuum, actuator 484, and/or other components of system 400. Controller 408 is configured to determine a second force (e.g., a force used during manufacturing) for coupling first substrate 403 to second substrate 405 based on the first force and the output signals, and/or other information. Controller 408 may be operatively coupled to the various components of system 400 wirelessly via a network (e.g., as represented by the cloud shape in Fig. 4), via wires, and/or in other ways.

In some embodiments, actuator 404 comprises a transmitter 410 configured to receive a control signal from controller 408 to cause actuator 404 to apply the first force. Actuator 404 may comprise a pin 412 configured to push on first substrate 403, a motor 414 configured to move pin 412, a load cell 416 configured to generate an output signal indicating the first force, and/or other components. In some embodiments, the first force comprises a force pulse 420. Force pulse 420 comprises a peak force, and a velocity with which the peak force is applied and/or removed. Actuator 404 is configured to apply the first force to a discrete portion 422 of first substrate 403 at or near a center of first substrate 403 (e.g., as shown in Fig. 4). Portion 422 and its immediate surrounding of the first substrate 403 deforms away from the substrate holder 402, in the current embodiment toward second substrate 405 as a result of the first force, without other areas (see areas of first substrate 403 to either side of portion 422 that are still in contact with holder 402) of first substrate 403 separating from substrate holder 402.

In some embodiments, sensor 406 comprises one or more electrodes configured to measure capacitance indicating the deformation of first substrate 403 toward second substrate 405 caused by the first force. An electrode is configured to induce local positive and/or negative charges 450 in substrate holder 402, and measure the capacitance based on the local positive and/or negative charges 450 in substrate holder 402. In some embodiments, sensor 406 comprises a plurality of electrodes coupled to substrate holder 402 in a plurality of locations. The plurality of locations are configured to facilitate measurement of capacitances in the plurality of locations across first substrate 403. In some embodiments, the plurality of electrodes comprise two electrodes each distributed at angles of 0°, 45°, 90°, 135°, 180°, 225°, 270°, and 315° around substrate holder 402, as shown in the top view 460 of substrate holder 402. In some embodiments, each sensor 406 may include various filters 485 and/or other electronic circuitry 487. Controller 408 is configured to determine the second force for coupling first 403 substrate to second substrate 405 based on the capacitances in the plurality of locations, the first force, and/or other information. In some embodiments, controller 408 is configured to convert a measured capacitance to a deformation distance (*dₒⱼ*, *dᵢⱼ*, etc.) between substrate holder 402 and first substrate 403, and determine the second force for coupling first substrate 403 to second substrate 405 based on deformation distances, the first force, and/or other information.

In some embodiments, controller 408 is configured to control actuator 404 to apply multiple different forces (and/or force pulses) to first substrate 403 that cause first substrate 403 to deform away from substrate holder 402 in different corresponding amounts toward second substrate 405. The one or more output signals generated by sensor 406 indicate the different corresponding amounts of deformation. Controller 408 is configured to determine the second force for coupling first substrate 403 to second substrate 405 based on the multiple different forces and the different corresponding amounts of deformation indicated in the output signals, and/or other information.

In some embodiments, the system comprises a gas (e.g., air or other gases) source 470 operably coupled to controller 408, substrate holder 402, and/or other components. Gas source 470 is configured to generate a pressurized flow of gas 472 to push first substrate 403 away from substrate holder 402 toward second substrate 405. Gas source 470 is controlled by controller 408.

In some embodiments, controller 408 is configured to determine material property information including an elastic modulus (E) for the first substrate, determine geometrical property (I) information for the first substrate, and/or determine a moment (M), based on the first force and the deformation indicated in the output signals, and/or other information. Controller 408 is configured to determine the second force for coupling first substrate 403 to second substrate 405 based on the material property information, the geometrical property information, the moment, and/or other information. In some embodiments, controller 408 is configured to determine a velocity (V) with which actuator 404 is to apply the second force, a separation distance (D) between first substrate 403 and second substrate 405, a release timing (T) of first substrate 403, a pressure (P) of pressurized flow of gas 472 configured to push first substrate 403 toward second substrate 405, and/or other coupling parameters, in addition to the second force (F), for coupling first substrate 403 to second substrate 405. These determinations may be based on the deformation indicated in the output signals, the first force, and/or other information.

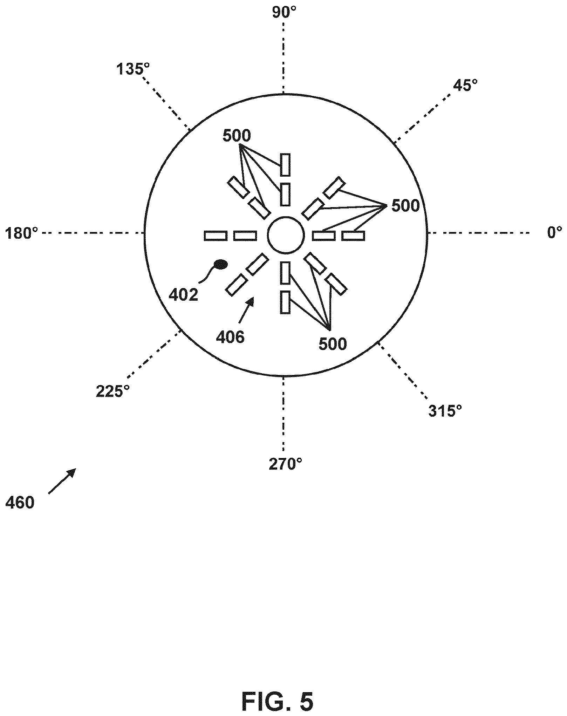

Fig. 5 provides an enlarged view of sensor 406 (in top view 460 of substrate holder 402). In Fig. 5, sensor 406 comprises a plurality of electrodes 500, which are similar to and/or the same as the electrodes described above with respect to Fig. 4. Electrodes 500 are each configured to measure capacitance indicating the deformation of a first substrate (e.g., substrate 403 shown in Fig. 4) toward a second substrate (e.g., 405 shown in Fig. 4). Each electrode 500 is configured to induce local positive and/or negative charges in substrate holder 402, and measure the capacitance based on the local positive and/or negative charges in substrate holder 402. As shown in Fig. 5, sensor 406 may comprise a plurality of electrodes 500 coupled to substrate holder 402 in a plurality of locations. The plurality of locations are configured to facilitate measurement of capacitances in the plurality of locations across a substrate. The plurality of electrodes 500 may comprise many electrode segments distributed at different angles around substrate holder 402. The number of segments may depend on the available space (e.g., given the locations of vacuums and the sizes of the vacuum locations and/or an electrode), granularity needed, and/or other factors. For example, the number of segments distributed at each angle around substrate holder 402 may be in the range of about 2< n < 5. As shown in the example in Fig. 5, in some embodiments, the plurality of electrodes comprise two electrodes each distributed at angles of 0°, 45°, 90°, 135°, 180°, 225°, 270°, and 315° around substrate holder 402. This particular design may be configured to accommodate a wafer (e.g., silicon) crystal orientation, for example.

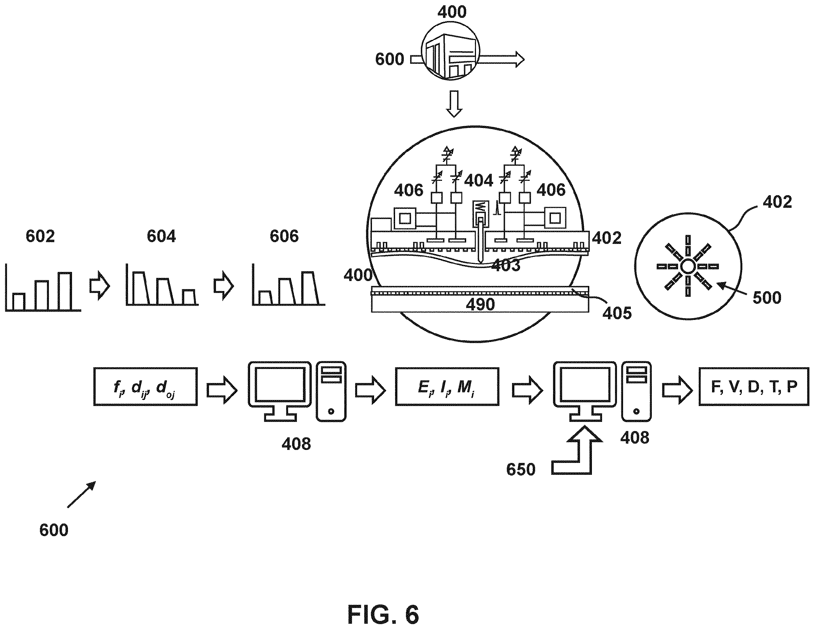

Fig. 6 illustrates a new coupling (e.g., bonding) process metrology and inspection flow 600 for controlling a coupling process using system 400 shown in Fig. 4. Flow 600 provides real-time or near real-time self-feedback control using substrate (e.g., wafer) deformation information on a chuck being used to process that particular substrate. In flow 600, additional material property information (compared to prior bonding processes) is determined and considered in a coupling process parameter determination. As described above, controller 408 (e.g., including one or more processors, a computing system, and/or other similar components) is configured to determine a force (e.g., a force used during manufacturing) for coupling first substrate 403 to second substrate 405 based on the force(s) applied to first substrate 403 and the output signals from sensors 406, and/or other information. In some embodiments, the force(s) comprise force pulses. Sensor 406 comprises one or more electrodes configured to measure capacitance indicating the deformation of first substrate 403 toward second substrate 405 caused by the force(s) in a plurality of locations. Controller 408 is configured to determine the force for coupling first 403 substrate to second substrate 405 based on the capacitances in the plurality of locations, the first force, and/or other information. In some embodiments, controller 408 is configured to convert a measured capacitance to a deformation distance (*dₒⱼ*, *dᵢⱼ*, etc.) between substrate holder 402 and first substrate 403, and determine the second force for coupling first substrate 403 to second substrate 405 based on deformation distances, the first force, and/or other information.

In some embodiments, controller 408 is configured to control actuator 404 to apply a single force or force pulse to first substrate 403 that causes first substrate 403 to deform away from substrate holder 402 in a corresponding amount (or in different corresponding amounts as a force pulse is applied) toward second substrate 405. In some embodiments, controller 408 is configured to control actuator 404 to apply multiple different forces (and/or force pulses) 602 to first substrate 403 that cause first substrate 403 to deform away from substrate holder 402 in different corresponding amounts toward second substrate 405. There are three different forces 602 (fi) applied in this example. This causes sensors 406 to measure multiple different corresponding capacitances 604. The one or more output signals generated by sensors 406 (e.g., the capacitances) indicate the different corresponding amounts of deformation 606 at various locations around first substrate 403. Controller 408 is configured to determine the force for coupling first substrate 403 to second substrate 405 based on the multiple different forces and the different corresponding amounts of deformation indicated in the output signals, and/or other information.

In some embodiments, controller 408 is configured to determine material property information including an elastic modulus (E or Ei) for the first substrate, determine geometrical property (I or Iᵢ) information for the first substrate, and/or determine a moment (M or Mᵢ), based on the force(s) and the deformation indicated in the output signals, and/or other information. Controller 408 is configured to determine second force (F) for coupling first substrate 403 to second substrate 405 based on the material property information, the geometrical property information, the moment, and/or other information. In some embodiments, controller 408 is configured to determine a velocity (V) with which actuator 404 is to apply the force (F), a separation distance (D) between first substrate 403 and second substrate 405, a release timing (T) of first substrate 403, a pressure (P) of pressurized flow of gas 472 configured to push first substrate 403 toward second substrate 405, and/or other coupling parameters, in addition to the force (F), for coupling first substrate 403 to second substrate 405. This may comprise computing optimized operation parameters as input for bonding process optimization, for example. These determinations may be based on the deformation indicated in the output signals, the first force, and/or other information. In some embodiments, measured post bonding overlay of previously paired wafers and/or other information 650 may be used to enhance these determinations. In some embodiments, controller 408 is configured to make one or more of these determinations mathematically, based on an electronic bonding model, and/or in other ways.

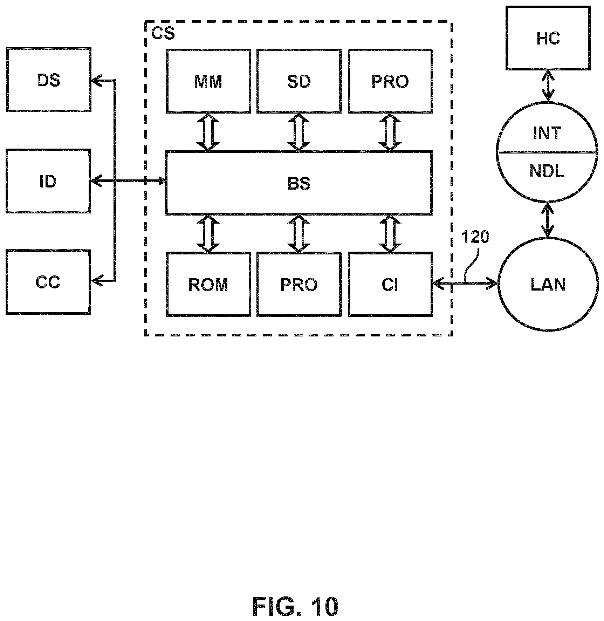

As described above, controller 408 may be configured to control one or more components of system 400 based on output signals from sensor(s) 406 and/or other information. This control may include adjustments made based on a target output signal and/or such that an output signal from a post bonding measurement matches a target output signal, for example. In some embodiments, the target output signal may comprise an expected output signal, an acceptable output signal range, and/or other target output signal. The controlling is performed with one or more processors configured by machine readable instructions based on the output signal(s) from sensor(s) 406 and/or other information (see Fig. 10 and computer system CS described below for further explanation related to the one or more processors).

In some embodiments, an output signal from a post bonding measurement (and/or combination of post bonding measurements) and/or a deviation of the output signal from a target output signal relative to one or more control commands from controller 408 is configured to be used as a feedback signal by the one or more processors to monitor bonding. Controller 408 is configured to generate one or more control signals for controlling various components of system 400 based on the feedback signal and/or other information.

In some embodiments, the components of system 400 communicate unidirectionally and/or bidirectionally with each other and/or other devices such as mobile user devices, a desk-top user device, external resources such as a server, and/or other devices. Each of these devices may communicate wirelessly and/or via wires. For example, each of these devices may communicate via a network, such as the Internet or the Internet in combination with various other networks, like local area networks, cellular networks, Wi-Fi networks, or personal area networks.

Mobile user devices may be smart phones, tablets, or other hand-held networked computing devices having a display, a user input device (e.g., buttons, keys, voice recognition, or a single or multi-touch touchscreen), memory (such as a tangible, machine-readable, non-volatile memory), a network interface, a portable energy source (e.g., a battery), and a processor (a term which, as used herein, includes one or more processors) coupled to each of these components. The memory of mobile user devices may store instructions that when executed by the associated processor provide an operating system and various applications, including a web browser or a native mobile application. A desktop user device may also include a web browser, for example. In addition, a desktop user device may include a monitor; a keyboard; a mouse; memory; a processor; and a tangible, non-transitory, machine-readable memory storing instructions that when executed by the processor provide an operating system and the web browser. Native applications and web browsers, in some embodiments, are operative to provide a graphical user interface associated with a user, for example, that communicates with system 400 and facilitates user interaction with data from system 400.

External resources, in some embodiments, include sources of information such as databases, websites, etc.; external entities participating with system 400; one or more servers outside of the system 400; a network (e.g., the internet); electronic storage; equipment related to Wi-Fi ^{™} technology; equipment related to Bluetooth^{®} technology; data entry devices; or other resources. In some implementations, some or all of the functionality attributed herein to external resources may be provided by resources included in system 400. External resources may be configured to communicate with one or more components of system 400 via wired and/or wireless connections, via a network (e.g., a local area network and/or the internet), via cellular technology, via Wi-Fi technology, and/or via other resources.

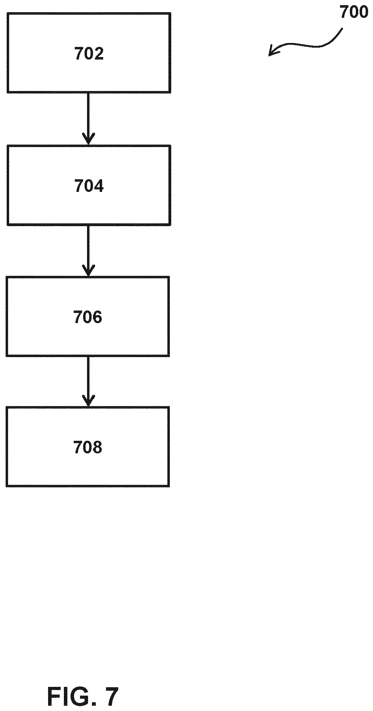

Fig. 7 illustrates a substrate coupling method 700. Method 700 may be similar to and/or the same as flow 600 shown in Fig. 6. Fig. 7 illustrates a sequence of actions, none limiting, describing substrate coupling. In some embodiments, one or more operations of method 700 may be implemented in or by a system described above, a computer system (e.g., as illustrated in Fig. 10 and described below), and/or in or by other systems, for example. In some embodiments, method 700 comprises holding (operation 702) a first substrate so that it can be coupled to a second substrate, applying (operation 704) a first force to the first substrate, generating (operation 706) output signals indicating deformation of the first substrate, determining (operation 708) a second force for coupling the first substrate to the second substrate, and/or other operations. The operations of method 700 are intended to be illustrative. In some embodiments, method 700 may be accomplished with one or more additional operations not described, and/or without one or more of the operations discussed. Additionally, the order in which the operations of method 700 are illustrated in Fig. 7 and described herein is not intended to be limiting.

In some embodiments, one or more portions of method 700 may be implemented in and/or controlled by one or more processing devices (e.g., a digital processor, an analog processor, a digital circuit designed to process information, an analog circuit designed to process information, a state machine, and/or other mechanisms for electronically processing information). The processing devices may be or be included in a computer system such as a desktop computer, a laptop computer, a smartphone, a server, and/or other computing devices, for example. The one or more processing devices may include one or more devices executing some or all of the operations of method 700 in response to instructions stored electronically on an electronic storage medium. The one or more processing devices may include one or more devices configured through hardware, firmware, and/or software to be specifically designed for execution of one or more of the operations of method 700.

Operation 702 comprises holding, with a substrate holder, a first substrate to enable the first substrate to be coupled to a second substrate. Coupling the first substrate to the second substrate comprises bonding the first substrate to the second substrate and/or other coupling. The substrate holder may comprise a chuck, for example. The substrates may comprise semiconductor wafers, dies, and/or other substrates. In some embodiments, the substrate holder comprises: burls configured to contact the first substrate, a plurality of vacuum channels coupled to a vacuum configured to provide a vacuum force to hold the first substrate against the burls; and an actuator configured to move the substrate holder and the first substrate relative to the second substrate. A second substrate holder may be configured to hold the second substrate. The second substrate holder may comprise second burls configured to contact the second substrate, and a second plurality of vacuum channels configured to provide a second vacuum force. The vacuum(s) and the actuator may be controlled by a controller, for example. In some embodiments, operation 702 is performed by a substrate holder similar to and/or the same as substrate holder 402 shown in Fig. 4.

Operation 704 comprises applying, with a different actuator coupled to the (first) substrate holder, a first force to the first substrate that causes the first substrate to deform away from the substrate holder toward the second substrate. The (different) actuator comprises a transmitter configured to receive a control signal from a controller to cause the actuator to apply the first force, a pin configured to push on the first substrate, a motor configured to move the pin, a load cell configure to generate an output signal indicating the first force, and/or other components. The first force may comprise a force pulse, for example. The force pulse may comprise a peak force, and a velocity with which the peak force is applied and/or removed. The actuator is configured to apply the first force to a discrete portion of the first substrate at or near a center of the first substrate. The portion of the first substrate and an immediate surrounding deforms away from the substrate holder toward the second substrate as a result of the first force, without other areas of the first substrate separating from the substrate holder. In some embodiments, operation 704 is performed by an actuator similar to and/or the same as actuator 404 shown in Fig. 4.

Operation 706 comprises generating, with a sensor coupled to the (first) substrate holder, one or more output signals indicating deformation of the first substrate toward the second substrate caused by the first force. The sensor comprises one or more electrodes configured to measure capacitance indicating the deformation of the first substrate toward the second substrate caused by the first force. An electrode is configured to induce local positive and/or negative charges in the substrate holder, and measure the capacitance based on the local positive and/or negative charges in the substrate holder. The sensor comprises a plurality of electrodes coupled to the substrate holder in a plurality of locations. The plurality of locations is configured to facilitate measurement of capacitances in the plurality of locations across the first substrate. For example, in one possible arrangement (other possibilities are described above), the plurality of electrodes comprise two electrodes each distributed at angles of 0°, 45°, 90°, 135°, 180°, 225°, 270°, and 315° around the substrate holder. In some embodiments, operation 706 is performed by a sensor similar to and/or the same as sensor 406 shown in Fig. 4.

Operation 708 comprises determining, with the controller, which is operatively coupled to the substrate holder, the actuator, and the sensor, a second force for coupling the first substrate to the second substrate based on the first force and the output signals. The controller may be and/or include one or more processors, a computing system, and/or other components. The controller is configured to determine the second force for coupling the first substrate to the second substrate based on the capacitances in the plurality of locations, and the first force. The controller is configured to convert a measured capacitance to a deformation distance between the substrate holder and the first substrate, and determine the second force for coupling the first substrate to the second substrate based on deformation distances, and the first force. In some embodiments, the controller is configured to control the actuator to apply multiple different forces to the first substrate that cause the first substrate to deform away from the substrate holder in different corresponding amounts toward the second substrate. The one or more output signals generated by the sensor indicate the different corresponding amounts of deformation. The controller is configured to determine the second force for coupling the first substrate to the second substrate based on the multiple different forces and the different corresponding amounts of deformation indicated in the output signals.

In some embodiments, the controller is configured to determine material property information including an elastic modulus (E) for the first substrate, determine geometrical property (I) information for the first substrate, and/or determine a moment (M), based on the first force and the deformation indicated in the output signals, and determine the second force for coupling the first substrate to the second substrate based on the material property information, the geometrical property information, and/or the moment. In some embodiments, the controller is configured to determine a velocity (V) with which the actuator is to apply the second force, a separation distance (D) between the first substrate and the second substrate, a release timing (T) of the first substrate, and/or a pressure (P) of a pressurized flow of gas configured to push the first substrate toward the second substrate, in addition to the second force (F), for coupling the first substrate to the second substrate, based on the deformation indicated in the output signals and the first force. In some embodiments, operation 708 is performed by controller similar to and/or the same as controller 408 shown in Fig. 4, which may be and/or include a computer system comprising one or more processors similar to and/or the same as computer system CS shown in Fig. 10.

In some embodiments, operation 708 comprises generating, with a gas source operably coupled to the controller and the substrate holder, a pressurized flow of gas to push the first substrate away from the substrate holder toward the second substrate, the gas source controlled by the controller.

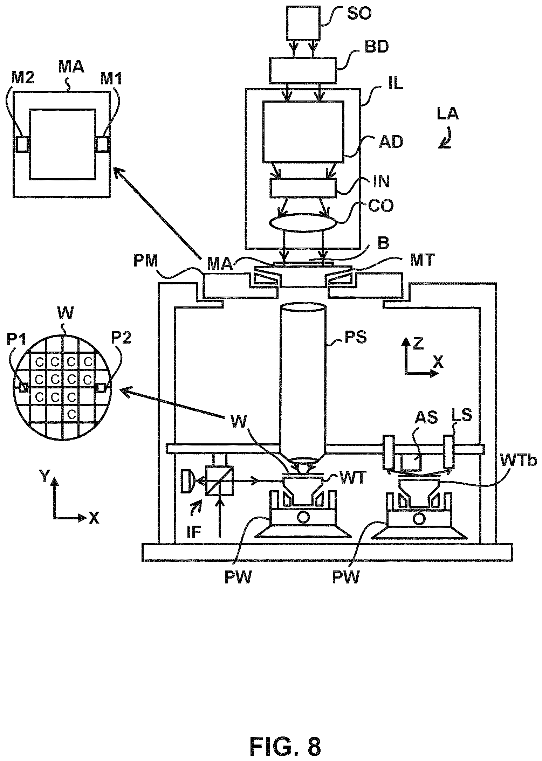

Fig. 8 schematically depicts an embodiment of a lithographic apparatus LA. Lithography may be performed prior to and/or after substrate (e.g., wafer) coupling (e.g., bonding) as described herein, for example. Fig. 8 shows a generic transmissive lithography apparatus. It should be noted that reflective or other variations on the system are possible, as are 'one-stage' machines. The apparatus LA comprises an illumination system (illuminator) IL configured to condition a radiation beam B (e.g. UV radiation, DUV radiation, or EUV radiation); a support structure (e.g. a mask table) MT constructed to support a patterning device (e.g. a mask) MA and connected to a first positioner PM configured to accurately position the patterning device in accordance with certain parameters; a substrate table (e.g. a wafer table) WT (e.g., WTa, WTb or both) configured to hold a substrate (e.g. a resist-coated wafer) W and coupled to a second positioner PW configured to accurately position the substrate in accordance with certain parameters; and a projection system (e.g. a refractive projection lens system) PS configured to project a pattern imparted to the radiation beam B by patterning device MA onto a target portion C (e.g. comprising one or more dice and often referred to as fields) of the substrate W. The projection system is supported on a reference frame RF. As depicted, the apparatus is of a transmissive type (e.g. employing a transmissive mask). Alternatively, the apparatus may be of a reflective type (e.g. employing a programmable mirror array, or employing a reflective mask).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases, the source may be an integral part of the apparatus, for example when the source is a mercury lamp. The source SO and the illuminator IL, together with the beam delivery system BD if required, may be referred to as a radiation system.

The illuminator IL may alter the intensity distribution of the beam. The illuminator may be arranged to limit the radial extent of the radiation beam such that the intensity distribution is non-zero within an annular region in a pupil plane of the illuminator IL. Additionally or alternatively, the illuminator IL may be operable to limit the distribution of the beam in the pupil plane such that the intensity distribution is non-zero in a plurality of equally spaced sectors in the pupil plane. The intensity distribution of the radiation beam in a pupil plane of the illuminator IL may be referred to as an illumination mode.

The illuminator IL may comprise adjuster AD configured to adjust the (angular / spatial) intensity distribution of the beam. Generally, at least the outer and/or inner radial extent (commonly referred to as σ-outer and σ-inner, respectively) of the intensity distribution in a pupil plane of the illuminator can be adjusted. The illuminator IL may be operable to vary the angular distribution of the beam. For example, the illuminator may be operable to alter the number, and angular extent, of sectors in the pupil plane wherein the intensity distribution is non-zero. By adjusting the intensity distribution of the beam in the pupil plane of the illuminator, different illumination modes may be achieved. For example, by limiting the radial and angular extent of the intensity distribution in the pupil plane of the illuminator IL, the intensity distribution may have a multi-pole distribution such as, for example, a dipole, quadrupole or hexapole distribution. A desired illumination mode may be obtained, e.g., by inserting an optic which provides that illumination mode into the illuminator IL or using a spatial light modulator.

The illuminator IL may be operable to alter the polarization of the beam and may be operable to adjust the polarization using adjuster AD. The polarization state of the radiation beam across a pupil plane of the illuminator IL may be referred to as a polarization mode. The use of different polarization modes may allow greater contrast to be achieved in the image formed on the substrate W. The radiation beam may be unpolarized. Alternatively, the illuminator may be arranged to linearly polarize the radiation beam. The polarization direction of the radiation beam may vary across a pupil plane of the illuminator IL. The polarization direction of radiation may be different in different regions in the pupil plane of the illuminator IL. The polarization state of the radiation may be chosen in dependence on the illumination mode. For multi-pole illumination modes, the polarization of each pole of the radiation beam may be generally perpendicular to the position vector of that pole in the pupil plane of the illuminator IL. For example, for a dipole illumination mode, the radiation may be linearly polarized in a direction that is substantially perpendicular to a line that bisects the two opposing sectors of the dipole. The radiation beam may be polarized in one of two different orthogonal directions, which may be referred to as X-polarized and Y-polarized states. For a quadrupole illumination mode, the radiation in the sector of each pole may be linearly polarized in a direction that is substantially perpendicular to a line that bisects that sector. This polarization mode may be referred to as XY polarization. Similarly, for a hexapole illumination mode the radiation in the sector of each pole may be linearly polarized in a direction that is substantially perpendicular to a line that bisects that sector. This polarization mode may be referred to as TE polarization.

In addition, the illuminator IL generally comprises various other components, such as an integrator IN and a condenser CO. The illumination system may include various types of optical components, such as refractive, reflective, magnetic, electromagnetic, electrostatic, or other types of optical components, or any combination thereof, for directing, shaping, or controlling radiation. Thus, the illuminator provides a conditioned beam of radiation B, having a desired uniformity and intensity distribution in its cross section.

The support structure MT supports the patterning device in a manner that depends on the orientation of the patterning device, the design of the lithographic apparatus, and other conditions, such as for example whether or not the patterning device is held in a vacuum environment. The support structure may use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

A patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted to reflect an incoming radiation beam in different directions. The tilted mirrors impart a pattern in a radiation beam, which is reflected by the mirror matrix.

The projection system PS may comprise a plurality of optical (e.g., lens) elements and may further comprise an adjustment mechanism configured to adjust one or more of the optical elements to correct for aberrations (phase variations across the pupil plane throughout the field). To achieve this, the adjustment mechanism may be operable to manipulate one or more optical (e.g., lens) elements within the projection system PS in one or more different ways. The projection system may have a coordinate system wherein its optical axis extends in the z direction. The adjustment mechanism may be operable to do any combination of the following: displace one or more optical elements; tilt one or more optical elements; and/or deform one or more optical elements. Displacement of an optical element may be in any direction (x, y, z, or a combination thereof). Tilting of an optical element is typically out of a plane perpendicular to the optical axis, by rotating about an axis in the x and/or y directions although a rotation about the z axis may be used for a non-rotationally symmetric aspherical optical element. Deformation of an optical element may include a low frequency shape (e.g. astigmatic) and/or a high frequency shape (e.g. free form aspheres). Deformation of an optical element may be performed for example by using one or more actuators to exert force on one or more sides of the optical element and/or by using one or more heating elements to heat one or more selected regions of the optical element. In general, it may not be possible to adjust the projection system PS to correct for apodization (transmission variation across the pupil plane). The transmission map of a projection system PS may be used when designing a patterning device (e.g., mask) MA for the lithography apparatus LA. Using a computational lithography technique, the patterning device MA may be designed to at least partially correct for apodization.

The lithographic apparatus may be of a type having two (dual stage) or more tables (e.g., two or more substrate tables WTa, WTb, two or more patterning device tables, a substrate table WTa and a table WTb below the projection system without a substrate that is dedicated to, for example, facilitating measurement, and/or cleaning, etc.). In such "multiple stage" machines, the additional tables may be used in parallel, or preparatory steps may be conducted on one or more tables while one or more other tables are being used for exposure. For example, alignment measurements using an alignment sensor AS and/or level (height, tilt, etc.) measurements using a level sensor LS may be made.

In operation of the lithographic apparatus LA, a radiation beam is conditioned and provided by the illumination system IL. The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder, 2-D encoder, or capacitive sensor), the substrate table WT can be moved accurately, e.g. to position different target portions C in the path of the radiation beam B. Similarly, the first positioner PM and another position sensor (which is not explicitly depicted in Fig. 4) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner), the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dice.

The substrate may be processed, before or after exposure, in for example a track (a tool that typically applies a layer of photosensitive resist ('photoresist') to a substrate and develops the exposed photoresist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already includes multiple processed layers.

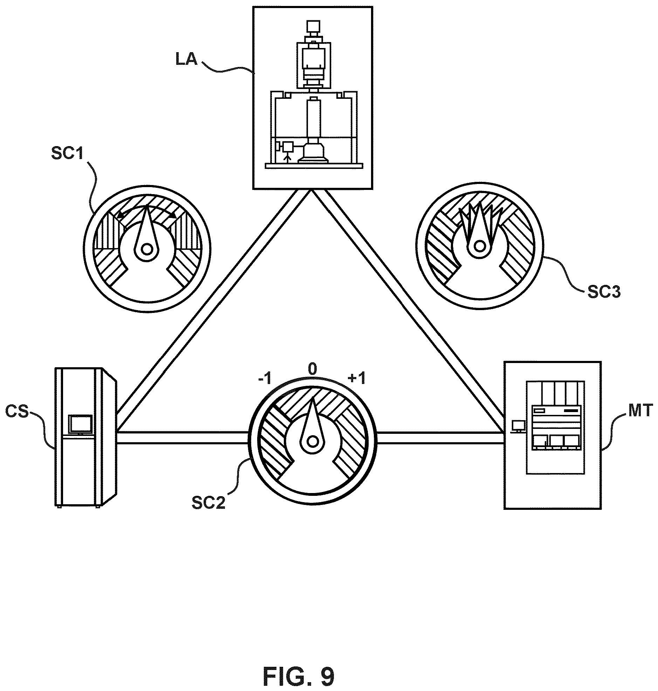

Fig. 9 depicts a schematic representation of holistic lithography, representing a cooperation between three technologies to optimize semiconductor processing, which may be performed prior to and/or after substrate (e.g., wafer) coupling (e.g., bonding) as described herein. Typically, the patterning process in a lithographic apparatus LA is one of the most critical steps in the processing which requires high accuracy of dimensioning and placement of structures on the substrate. To ensure this high accuracy, three systems (in this example) may be combined in a so called "holistic" control environment as schematically depicted in Fig. 9. One of these systems is the lithographic apparatus LA which is (virtually) connected to a metrology apparatus (e.g., a metrology tool) MT (a second system), and to a computer system CS (a third system). A "holistic" environment may be configured to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific processing process yields a defined result (e.g. a functional semiconductor device) - typically within which the process parameters in the lithographic process or patterning process are allowed to vary.

The computer system CS may use a design layout to be patterned to predict which resolution enhancement techniques to use and to perform computational lithography simulations and calculations to determine which mask layout and lithographic apparatus settings achieve the largest overall process window of the patterning process (depicted in Fig. 9 by the double arrow in the first scale SC1). Typically, the resolution enhancement techniques are arranged to match the patterning possibilities of the lithographic apparatus LA. The computer system CS may also be used to detect where within the process window the lithographic apparatus LA is currently operating (e.g. using input from the metrology tool MT) to predict whether defects may be present due to e.g. sub-optimal processing (depicted in Fig. 9 by the arrow pointing "0" in the second scale SC2).

The metrology apparatus (tool) MT may provide input to the computer system CS to enable accurate simulations and predictions, and may provide feedback to the lithographic apparatus LA to identify possible drifts, e.g. in a calibration status of the lithographic apparatus LA (depicted in Fig. 9 by the multiple arrows in the third scale SC3).

In lithographic processes, it is desirable to make frequent measurements of the structures created, e.g., for process control and verification. Tools to make such measurements include metrology tool (apparatus) MT. Different types of metrology tools MT for making such measurements are known, including scanning electron microscopes or various forms of scatterometer metrology tools MT. Scatterometers are inspection instruments that allow measurements of the parameters of a lithographic process by having a sensor in the pupil or a conjugate plane with the pupil of the objective of the scatterometer, these measurements are usually referred as pupil-based measurements, or by having the sensor in the image plane or a plane conjugate with the image plane, in which case the measurements are usually referred as image or field-based measurements.

It is often desirable to be able to computationally determine how a patterning process would produce a desired pattern on a substrate. Computational determination may comprise simulation, for example. Simulations may be provided for one or more parts of the processing process. For example, it is desirable to be able to simulate the lithography process of transferring the patterning device pattern onto a resist layer of a substrate as well as the yielded pattern in that resist layer after development of the resist, simulate metrology operations such as the determination of overlay, and/or perform other simulations. The objective of a simulation may be to accurately predict, for example, metrology metrics (e.g., overlay, a critical dimension, a reconstruction of a three dimensional profile of features of a substrate, a dose or focus of a lithography apparatus at a moment when the features of the substrate were printed with the lithography apparatus, etc.), processing process parameters (e.g., edge placements, aerial image intensity slopes, sub-resolution assist features (SRAFs), etc.), and/or other information which can then be used to determine whether an intended or target design has been achieved.

Fig. 10 is a diagram of an example computer system CS that may be used for one or more of the operations described herein (e.g., one or more of the operations of method 700 shown in Fig. 7 and/or other operations). Computer system CS may be included in and/or be similar to and/or the same as the controller described above (e.g., computer system CS may form some or all of the controller described above). Computer system CS includes a bus BS or other communication mechanism for communicating information, and a processor PRO (or multiple processors) coupled with bus BS for processing information. Computer system CS also includes a main memory MM, such as a random access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a flat panel or touch panel display or a cathode ray tube (CRT) for displaying information to a computer user or observer. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, all or some of one or more operations described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" or "machine-readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

Various embodiments of the present systems and methods are disclosed in the subsequent list of numbered clauses. In the following, further features, characteristics, and exemplary technical solutions of the present disclosure will be described in terms of clauses that may be optionally claimed in any combination:
1. A substrate coupling system, comprising: a substrate holder configured to hold a first substrate to enable the first substrate to be coupled to a second substrate; an actuator coupled to the substrate holder, the actuator configured to apply a first force to the first substrate that causes the first substrate to deform away from the substrate holder; a sensor coupled to the substrate holder, the sensor configured to generate one or more output signals indicating deformation of the first substrate caused by the first force; and a controller operatively coupled to the substrate holder, the actuator, and the sensor, the controller configured to determine a second force for coupling the first substrate to the second substrate based on the first force and the output signals.
2. The system of clause 1, wherein the substrate holder comprises a chuck, and wherein the first force is configured to deform the first substrate away from the substrate holder toward the second substrate.
3. The system of any of the previous clauses, wherein coupling the first substrate to the second substrate comprises bonding the first substrate to the second substrate.
4. The system of any of the previous clauses, wherein the actuator comprises a transmitter configured to receive a control signal from the controller to cause the actuator to apply the first force, a pin configured to push on the first substrate, a motor configured to move the pin, and a load cell configure to generate an output signal indicating the first force.
5. The system of any of the previous clauses, wherein the first force comprises a force pulse, the force pulse comprising a peak force, and a velocity with which the peak force is applied and/or removed.
6. The system of any of the previous clauses, wherein the actuator is configured to apply the first force to a discrete portion of the first substrate at or near a center of the first substrate.
7. The system of any of the previous clauses, wherein the discrete portion of the first substrate together with its immediate surrounding deforms away from the substrate holder as a result of the first force, without other areas of the first substrate separating from the substrate holder.
8. The system of any of the previous clauses, wherein the first substrate and the second substrate comprise semiconductor wafers.
9. The system of any of the previous clauses, wherein the first substrate and the second substrate comprise dies.
10. The system of any of the previous clauses, wherein the sensor comprises one or more electrodes configured to measure capacitance indicating the deformation of the first substrate toward the second substrate caused by the first force.
11. The system of any of the previous clauses, wherein an electrode is configured to induce local positive and/or negative charges in the substrate holder, and measure the capacitance based on the local positive and/or negative charges in the substrate holder.
12. The system of any of the previous clauses, wherein: the sensor comprises a plurality of electrodes coupled to the substrate holder in a plurality of locations, the plurality of locations configured to facilitate measurement of capacitances in the plurality of locations across the first substrate, the plurality of electrodes comprise two electrodes each distributed at angles of 0°, 45°, 90°, 135°, 180°, 225°, 270°, and/or 315° around the substrate holder, and the controller is configured to determine the second force for coupling the first substrate to the second substrate based on the capacitances in the plurality of locations, and the first force.
13. The system of any of the previous clauses, wherein the controller is configured to convert a measured capacitance to a deformation distance between the substrate holder and the first substrate, and determine the second force for coupling the first substrate to the second substrate based on deformation distances, and the first force.
14. The system of any of the previous clauses, wherein: the controller is configured to control the actuator to apply multiple different forces to the first substrate that cause the first substrate to deform away from the substrate holder in different corresponding amounts toward the second substrate; the one or more output signals generated by the sensor indicate the different corresponding amounts of deformation; and the controller is configured to determine the second force for coupling the first substrate to the second substrate based on the multiple different forces and the different corresponding amounts of deformation indicated in the output signals.
15. The system of any of the previous clauses, further comprising a gas source operably coupled to the controller and the substrate holder, and configured to generate a pressurized flow of gas to push the first substrate away from the substrate holder toward the second substrate, the gas source controlled by the controller.
16. The system of any of the previous clauses, wherein the controller is further configured to:
   determine material property information including an elastic modulus (E) for the first substrate, determine geometrical property (I) information for the first substrate, and/or determine a moment (M), based on the first force and the deformation indicated in the output signals, and determine the second force for coupling the first substrate to the second substrate based on the material property information, the geometrical property information, and/or the moment.
17. The system of any of the previous clauses, wherein the controller is further configured to determine: a velocity (V) with which the actuator is to apply the second force, a separation distance (D) between the first substrate and the second substrate, a release timing (T) of the first substrate, and/or a pressure (P) of a pressurized flow of gas configured to push the first substrate toward the second substrate, in addition to the second force (F), for coupling the first substrate to the second substrate, based on the deformation indicated in the output signals and the first force.
18. The system of any of the previous clauses, wherein the controller comprises one or more processors.
19. The system of any of the previous clauses, wherein the substrate holder comprises: burls configured to contact the first substrate, a plurality of vacuum channels coupled to a vacuum configured to provide a vacuum force to hold the first substrate against the burls; and a second actuator configured to move the substrate holder and the first substrate relative to the second substrate, wherein the vacuum and the second actuator are controlled by the controller.
20. The system of any of the previous clauses, further comprising a second substrate holder configured to hold the second substrate, the second substrate holder comprising second burls configured to contact the second substrate, and a second plurality of vacuum channels configured to provide a second vacuum force controlled by the controller to hold the second substrate against the second burls.
21. A substrate coupling method, comprising: holding, with a substrate holder, a first substrate to enable the first substrate to be coupled to a second substrate; applying, with an actuator coupled to the substrate holder, a first force to the first substrate that causes the first substrate to deform away from the substrate holder; generating, with a sensor coupled to the substrate holder, one or more output signals indicating deformation of the first substrate caused by the first force; and determining, with a controller operatively coupled to the substrate holder, the actuator, and the sensor, a second force for coupling the first substrate to the second substrate based on the first force and the output signals.
22. The method of clause 21, wherein the substrate holder comprises a chuck, and wherein the first force is configured to deform the first substrate away from the substrate holder toward the second substrate.
23. The method of any of the previous clauses, wherein coupling the first substrate to the second substrate comprises bonding the first substrate to the second substrate.
24. The method of any of the previous clauses, wherein the actuator comprises a transmitter configured to receive a control signal from the controller to cause the actuator to apply the first force, a pin configured to push on the first substrate, a motor configured to move the pin, and a load cell configure to generate an output signal indicating the first force.
25. The method of any of the previous clauses, wherein the first force comprises a force pulse, the force pulse comprising a peak force, and a velocity with which the peak force is applied and/or removed.
26. The method of any of the previous clauses, wherein the actuator is configured to apply the first force to a discrete portion of the first substrate at or near a center of the first substrate.
27. The method of any of the previous clauses, wherein the discrete portion of the first substrate and its immediate surrounding deforms away from the substrate holder as a result of the first force, without other areas of the first substrate separating from the substrate holder.
28. The method of any of the previous clauses, wherein the first substrate and the second substrate comprise semiconductor wafers.
29. The method of any of the previous clauses, wherein the first substrate and the second substrate comprise dies.
30. The method of any of the previous clauses, wherein the sensor comprises one or more electrodes configured to measure capacitance indicating the deformation of the first substrate toward the second substrate caused by the first force.
31. The method of any of the previous clauses, wherein an electrode is configured to induce local positive and/or negative charges in the substrate holder, and measure the capacitance based on the local positive and/or negative charges in the substrate holder.
32. The method of any of the previous clauses, wherein: the sensor comprises a plurality of electrodes coupled to the substrate holder in a plurality of locations, the plurality of locations configured to facilitate measurement of capacitances in the plurality of locations across the first substrate, the plurality of electrodes comprise two electrodes each distributed at angles of 0°, 45°, 90°, 135°, 180°, 225°, 270°, and/or 315° around the substrate holder, and the controller is configured to determine the second force for coupling the first substrate to the second substrate based on the capacitances in the plurality of locations, and the first force.
33. The method of any of the previous clauses, wherein the controller is configured to convert a measured capacitance to a deformation distance between the substrate holder and the first substrate, and determine the second force for coupling the first substrate to the second substrate based on deformation distances, and the first force.
34. The method of any of the previous clauses, wherein: the controller is configured to control the actuator to apply multiple different forces to the first substrate that cause the first substrate to deform away from the substrate holder in different corresponding amounts toward the second substrate; the one or more output signals generated by the sensor indicate the different corresponding amounts of deformation; and the controller is configured to determine the second force for coupling the first substrate to the second substrate based on the multiple different forces and the different corresponding amounts of deformation indicated in the output signals.
35. The method of any of the previous clauses, further comprising generating, with a gas source operably coupled to the controller and the substrate holder, a pressurized flow of gas to push the first substrate away from the substrate holder toward the second substrate, the gas source controlled by the controller.
36. The method of any of the previous clauses, wherein the controller is further configured to:
   determine material property information including an elastic modulus (E) for the first substrate, determine geometrical property (I) information for the first substrate, and/or determine a moment (M), based on the first force and the deformation indicated in the output signals, and determine the second force for coupling the first substrate to the second substrate based on the material property information, the geometrical property information, and/or the moment.
37. The method of any of the previous clauses, wherein the controller is further configured to determine: a velocity (V) with which the actuator is to apply the second force, a separation distance (D) between the first substrate and the second substrate, a release timing (T) of the first substrate, and/or a pressure (P) of a pressurized flow of gas configured to push the first substrate toward the second substrate, in addition to the second force (F), for coupling the first substrate to the second substrate, based on the deformation indicated in the output signals and the first force.
38. The method of any of the previous clauses, wherein the controller comprises one or more processors.
39. The method of any of the previous clauses, wherein the substrate holder comprises: burls configured to contact the first substrate, a plurality of vacuum channels coupled to a vacuum configured to provide a vacuum force to hold the first substrate against the burls; and a second actuator configured to move the substrate holder and the first substrate relative to the second substrate, wherein the vacuum and the second actuator are controlled by the controller.
40. The method of any of the previous clauses, further comprising a second substrate holder configured to hold the second substrate, the second substrate holder comprising second burls configured to contact the second substrate, and a second plurality of vacuum channels configured to provide a second vacuum force controlled by the controller to hold the second substrate against the second burls.

The descriptions above are intended to be illustrative, not limiting. Thus, it will be apparent to one skilled in the art that modifications may be made as described without departing from the scope of the claims set out below.

## Claims

1. A substrate coupling system, comprising:
a substrate holder configured to hold a first substrate to enable the first substrate to be coupled to a second substrate;
an actuator coupled to the substrate holder, the actuator configured to apply a first force to the first substrate that causes the first substrate to deform away from the substrate holder;
a sensor coupled to the substrate holder, the sensor configured to generate one or more output signals indicating deformation of the first substrate caused by the first force; and
a controller operatively coupled to the substrate holder, the actuator, and the sensor, the controller configured to determine a second force for coupling the first substrate to the second substrate based on the first force and the output signals.

2. The system of claim 1, wherein the substrate holder comprises a chuck, and wherein the first force is configured to deform the first substrate away from the substrate holder toward the second substrate.

3. The system of claims 1 or 2, wherein coupling the first substrate to the second substrate comprises bonding the first substrate to the second substrate.

4. The system of claim 1, wherein the actuator comprises a transmitter configured to receive a control signal from the controller to cause the actuator to apply the first force, a pin configured to push on the first substrate, a motor configured to move the pin, and a load cell configure to generate an output signal indicating the first force.

5. The system of claim 1, wherein the first force comprises a force pulse, the force pulse comprising a peak force, and a velocity with which the peak force is applied and/or removed.

6. The system of claim 1, wherein the actuator is configured to apply the first force to a discrete portion of the first substrate at or near a center of the first substrate.

7. The system of claim 6, wherein the discrete portion of the first substrate and an immediate surrounding deforms away from the substate holder as a result of the first force, without other areas of the first substrate separating from the substrate holder.

8. The system of claim 1, wherein the sensor comprises one or more electrodes configured to measure capacitance indicating the deformation of the first substrate caused by the first force.

9. The system of claim 8, wherein an electrode is configured to induce local positive and/or negative charges in the substrate holder, and measure the capacitance based on the local positive and/or negative charges in the substrate holder.

10. The system of claims 8 or 9, wherein:
the sensor comprises a plurality of electrodes coupled to the substrate holder in a plurality of locations, the plurality of locations configured to facilitate measurement of capacitances in the plurality of locations across the first substrate,
the plurality of electrodes comprise two electrodes each distributed at angles of 0°, 45°, 90°, 135°, 180°, 225°, 270°, and/or 315° around the substrate holder, and
the controller is configured to determine the second force for coupling the first substrate to the second substrate based on the capacitances in the plurality of locations, and the first force.

11. The system of claim 8, wherein the controller is configured to convert a measured capacitance to a deformation distance between the substrate holder and the first substrate, and determine the second force for coupling the first substrate to the second substrate based on deformation distances, and the first force.

12. The system of claim 1, wherein:
the controller is configured to control the actuator to apply multiple different forces to the first substrate that cause the first substrate to deform away from the substrate holder in different corresponding amounts;
the one or more output signals generated by the sensor indicate the different corresponding amounts of deformation; and
the controller is configured to determine the second force for coupling the first substrate to the second substrate based on the multiple different forces and the different corresponding amounts of deformation indicated in the output signals.

13. The system of claim 1, further comprising a gas source operably coupled to the controller and the substrate holder, and configured to generate a pressurized flow of gas to push the first substrate away from the substrate holder, the gas source controlled by the controller.

14. The system of claim 1, wherein the controller is further configured to:
determine material property information including an elastic modulus (E) for the first substrate, determine geometrical property (I) information for the first substrate, and/or determine a moment (M), based on the first force and the deformation indicated in the output signals, and
determine the second force for coupling the first substrate to the second substrate based on the material property information, the geometrical property information, and/or the moment.

15. The system of claim 1, wherein the controller is further configured to determine:
a velocity (V) with which the actuator is to apply the second force,
a separation distance (D) between the first substrate and the second substrate,
a release timing (T) of the first substrate, and/or
a pressure (P) of a pressurized flow of gas configured to push the first substrate toward the second substrate,
in addition to the second force (F),
for coupling the first substrate to the second substrate, based on the deformation indicated in the output signals and the first force.
